Europäisches Patentamt

European Patent Office

Office européen des brevets

(19)

(11)  EP 1 095 378 B1

(12)  **FASCICULE DE BREVET EUROPEEN**

(45) Date de publication et mention
de la délivrance du brevet:
**19.10.2005  Bulletin 2005/42**

(21) Numéro de dépôt: **99929473.9**

(22) Date de dépôt: **09.07.1999**

(51) Int Cl.⁷: $G21G\ 1/08$

(86) Numéro de dépôt international:
**PCT/FR1999/001696**

(87) Numéro de publication internationale:
**WO 2000/003399 (20.01.2000 Gazette 2000/03)**

(54) **CIBLE PRIMAIRE POUR LA FORMATION DE PRODUITS DE FISSION**

PRIMÄRZIEL ZUR ERZEUGUNG VON SPALTPRODUKTEN

PRIMARY TARGET FOR FORMING FISSION PRODUCTS

(84) Etats contractants désignés:
**DK FR GB**

(30) Priorité: **09.07.1998  FR 9809001**

(43) Date de publication de la demande:
**02.05.2001  Bulletin 2001/18**

(73) Titulaire: **C.E.R.C.A. (Compagnie pour l'etude et
la réalisation de combustibles atomiques)
92084 Paris Cedex (FR)**

(72) Inventeurs:
• **DURAND, Jean-Pierre
F-26300 Chatuzange Le Goubet (FR)**
• **LAVASTRE, Yves
F-38840 St. Hilaire du Rosier (FR)**
• **LAUDAMY, Patrick
F-38420 Domene (FR)**

(74) Mandataire: **Tilloy, Anne-Marie et al
IXAS Conseil,
15, rue Emile Zola
69002 Lyon (FR)**

(56) Documents cités:
**DE-A- 2 725 206**          **FR-A- 2 356 243**
**US-A- 3 940 318**

## Description

L'invention concerne une cible primaire pour la production d'un produit de fission dans un réacteur nucléaire.

L'invention a plus particulièrement pour objet une cible primaire pour la formation du produit de fission molybdène-99 à de fortes concentrations, de forte activité spécifique et de haut degré de pureté.

L'invention concerne également des méthodes de préparation de la cible.

L'invention concerne enfin l'utilisation de molybdène-99 résultant de l'irradiation de la cible primaire, dans un réacteur nucléaire, pour la production de technécium-99 à des fins de recherches et/ou de diagnostics médicaux et/ou industriels.

## Etat de la technique

Le radio-isotope molybdène-99 est utilisé depuis longtemps comme source du technécium-99 exploité sous une forme pure en recherches et diagnostics médicaux et/ou industriels. Le technécium-99 s'est, en effet, révélé particulièrement intéressant comme traceur, quand il est introduit dans le milieu à examiner, en raison de sa courte période qui permet de réduire l'exposition de ce milieu à l'irradiation.

Dans le domaine médical, le technécium-99 s'est manifesté être un moyen particulièrement utile en recherche ou en diagnostic clinique, par exemple pour l'exploration d'organes du corps humain (tels que foie, poumon, sang, etc.) et la détection des anomalies (cancer).

Dans le domaine industriel, le technécium-99 s'est montré être un excellent outil, par exemple pour la mesure de débits de liquides ou encore pour l'observation de procédés et leur optimisation (en chimie).

Comme le technécium-99 a une courte période de radioactivité (environ 6 heures), il est généralement généré sur le site d'utilisation au moment de la demande, par son extraction de l'élément dont il dérive, c'est-à-dire du molybdène-99 radioactif.

Mais pour être exploitable, le molybdène-99 doit avoir un degré de pureté très élevé et une activité spécifique forte.

Pour ces usages, le molybdène-99 radioactif chimiquement pur est habituellement adsorbé sur colonne d'alumine. Cette colonne qui constitue le générateur de technécium-99 est soumise par l'utilisateur du radio-isotope à une extraction à la demande par élution au moyen d'un milieu éluant approprié. La solution de technécium-99 est, dès lors, opérationnelle.

En diagnostic médical par exemple, la solution de technécium-99 est administrée par voie intraveineuse ou encore par voie orale. Selon la spécificité apportée à la préparation de la solution de technécium-99, ledit élément se fixe préférentiellement sur l'organe ciblé qui peut être ensuite soumis à un diagnostic clinique par une méthode typique d'exploration de la radioactivité.

En application industrielle, la solution de technécium-99 est introduite dans le dispositif à étudier, puis les débits et circulations des fluides sont mesurés à l'aide d'un compteur typique d'exploration de la radioactivité.

Plusieurs voies ont été pratiquées et décrites pour la production de molybdène-99 radioactif, source ultérieure de technécium-99. Chacune de ces voies met en oeuvre une cible primaire réalisée au moyen d'une matière fissile adéquate, cette cible étant soumise à irradiation neutronique dans un réacteur nucléaire pour la formation du produit de fission molybdene-99.

De manière connue, les cibles primaires sont formées de surfaces planes, de surfaces courbes, voire tubulaires.

Selon une première voie, il est proposé d'utiliser du molybdène naturel dans la cible, ultérieurement irradié en réacteur, puis après extraction chimique du molybdène-99, exploité comme générateur médical de technécium-99 (US-A-3382152).

Selon cette première voie, l'isotope molybdène-99 obtenu par irradiation a généralement un haut degré de pureté radioactive et le traitement chimique de la cible pour l'extraire est simple et conduit à une solution pure d'élution du technécium-99. Mais, le rendement pondéral d'irradiation du molybdène-99 sur le molybdène initial est très faible.

Selon une autre voie d'un rendement pondéral bien plus élevé, il est proposé d'utiliser de l'uranium ou un alliage dans la cible primaire et à irradier cette cible au réacteur nucléaire pour fabriquer le produit de fission molybdène-99.

Quand la matière fissile mise en oeuvre dans la réalisation de la cible est de l'uranium, ledit uranium peut être mis en forme à l'état pur ou allié, selon la métallurgie des poudres, ou déposé selon des méthodes électrolytiques sur le substrat destiné à le supporter.

Selon un premier type, dit type I par la suite, une cible primaire à base d'uranium destinée par irradiation à former du molybdène-99 radioactif a été réalisée en associant :

- un noyau uranifère formé par la métallurgie des poudres, d'un alliage d'uranium et d'aluminium du type $UAl_x$;

- et des plaques d'aluminium.

La mise en oeuvre d'un alliage d'uranium, par exemple uranium-aluminium (UAl$_x$), procure une plus grande stabilité dimensionnelle à la cible mise sous irradiation que la mise en oeuvre du seul uranium métal.

Plus précisément, le procédé de réalisation d'une telle cible primaire consiste à préparer par fusion, par exemple un alliage UAl$_x$ (dans lequel x prend la valeur 3 ou 4) à partir d'uranium et d'aluminium, à broyer finement cet alliage, à le combiner à de la poudre d'aluminium en quantité adéquate, puis à comprimer fortement sous presse le mélange pulvérulent ainsi préparé, selon la méthode de la métallurgie des poudres précitée jusqu'à réaliser un noyau uranifère.

Le noyau uranifère obtenu est alors encadré par des plaques d'aluminium. L'ensemble ainsi formé par le noyau et les plaques constitue la cible qui est soumise à irradiation en vue d'obtenir le molybdène-99 radioactif. Mais une telle cible stratifiée par association d'alliage uranium-aluminium et d'aluminium présente des limites technologiques de réalisation qui se manifestent comme des inconvénients.

En effet, à travers la forme associée de l'uranium et de l'aluminium dans le noyau, la quantité (exprimée en g) d'uranium total (exprimé sous l'abréviation Ut dans la suite de la description) présent dans la cible par unité de volume (exprimée en cm$^3$) est trop faible (environ 1,1 g Ut/cm3), (si l'alliage de stratification est de l'aluminium pur), ce qui conduit à une faible productivité ultérieure en molybdène-99, mais qui est cependant supérieure à celle résultant de l'irradiation du molybdène naturel.

Selon un autre type, dit type II par la suite, une cible primaire à base d'uranium a été constituée par la formation de dépôt de la matière fissile sur un substrat porteur. Cette cible primaire (comme décrit dans le US-A-3940318) est formée d'un récipient cylindrique clos, réalisé en métal ou alliage, dont la surface interne est revêtue d'une mince couche adhérente de la matière fissile (composés de l'uranium), dont elle peut être retirée, après irradiation de la cible, par un traitement chimique approprié, sans détérioration significative du support. Mais ce type de cible primaire présente des limites technologiques de réalisation, car la quantité d'uranium par cible est limitée par l'épaisseur relativement faible de la couche du composé d'uranium déposé avec les technologies existantes et la matière fissile mise en oeuvre (alliage d'uranium).

Dès lors, en raison des inconvénients précités, l'invention se donne pour objectif premier leur élimination par la réalisation d'une cible primaire améliorée pour la production du produit de fission molybdène-99 à forte concentration, de forte activité spécifique et haut degré de pureté après extraction du milieu irradié, en vue d'être utilisée à la demande pour la production du technécium-99 sans pour autant modifier la chimie d'extraction du molybdène-99, à éléments de structures identiques.

Un autre objectif concerne l'obtention de cibles primaires destinées à l'irradiation neutronique se présentant indifféremment sous la forme de pastilles, de plaques planes, ou au moins partiellement cylindriques, ou autres.

Un autre objectif concerne la réalisation de cibles primaires, à partir d'une matière fissile à base d'uranium permettant une simplification du cycle de ladite matière fissile dans la phase de réalisation de la cible (en amont) et dans la phase de séparation post-irradiation du molybdène-99 de l'uranium à recycler (en aval).

## Sommaire de l'invention

L'invention concerne une nouvelle cible primaire pour la production par irradiation neutronique dans un réacteur nucléaire d'un produit de fission, le 99 Mo, à partir d'une matière fissile à base d'uranium, , qui se caractérise en ce que la matière fissile est majoritairement constituée, en masse, de nitrure d'uranium.

## Exposé détaillé de l'invention

De nombreuses caractéristiques et avantages de l'invention apparaîtront dans sa description détaillée.

Par rapport à l'état de la technique, l'invention concerne donc une cible primaire améliorée dont la matière fissile est majoritairement constituée, en masse, de nitrure d'uranium qui par irradiation dans un réacteur nucléaire à flux neutronique conduit à la formation du produit de fission molybdène-99 à forte concentration, à forte activité spécifique, et ayant un haut degré de pureté après son extraction post-irradiation. Le molybdène-99 ainsi obtenu peut être utilisé à la demande pour la production du 99 Tc.

Le nitrure d'uranium (UN) mis en oeuvre dans la réalisation de la cible selon l'invention peut être obtenu selon tout procédé connu, tel que, par exemple, la nitruration directe de l'uranium métal, la réduction carbothermique d'oxydes d'uranium dans un milieu gazeux contenant de l'azote et de l'hydrogène en quantités appropriées, selon les réactions suivantes :

$$1/3 \ U_3O_8 + 1/3 \ C \Rightarrow UO_2 + 1/3 \ CO_2 \quad UO_2 + 2 \ C + \tfrac{1}{2} \ N_2 \Rightarrow UN + 2 \ CO$$

ou encore la transformation de fluorure d'uranium ($UF_6$) en nitrure d'uranium (UN) par l'action d'un mélange d'azote et d'hydrogène ou d'ammoniac selon les réactions suivantes :

$$UF_6 + \tfrac{1}{2}\, N_2 + 3\, H_2 \Rightarrow UN + 6\, HF$$

ou

$$UF_6 + NH_3 + 3/2\, H_2 \Rightarrow UN + 6\, HF$$

ou encore

$$UF_6 + 2\, NH_3 \Rightarrow UN + 6\, HF + \tfrac{1}{2}\, N_2$$

L'$UF_6$ issu des unités d'enrichissement, peut être directement mis en oeuvre pour l'obtention d'UN, simplifiant ainsi le cycle de préparation de la matière fissile en amont de la phase de réalisation de la cible. Quant à l'acide fluorhydrique formé (HF), il est piégé à la sortie de l'enceinte de sa formation par un moyen connu.

La cible primaire selon l'invention peut être réalisée :

- selon un premier type, dit type I par la suite, à partir de noyaux préparés selon la méthode de la métallurgie des poudres au moyen d'un mélange en poudre d' UN et d'un métal, de granulométries appropriées, se présentant ultérieurement sous la forme de volumes appropriés, tel que plaques planes ou courbes... Dans le cadre de ce type de cible, la « matière fissile », décrite dans la présente demande, correspond au mélange de poudre d'UN et de poudre de métal.

- selon un autre type, dit type II par la suite, à partir de substrats tels que plaques planes ou courbes, revêtues d'un film adhérent d'UN réalisé par l'un des moyens connus permettant le dépôt d'une couche continue et régulière d'UN, d'épaisseur adéquate, tels que par exemple par dépôt, par évaporation sous vide (vacuum deposition), par dépôts chimiques d'une phase gazeuse (Chemical vapor deposition : C.V.D.), par dépôts physiques en phase vapeur (Physic vapor deposition : P.V.D.), par pulvérisation (spray painting, suspensions spraying)... Dans le cadre de ce type de cible, la « matière fissile », décrite dans la présente demande, correspond à la couche d'UN déposée.

Selon une première méthode de réalisation d'une cible selon l'invention, dite de type I, à partir d'un noyau préparé par la métallurgie des poudres, par mélange de poudres d'UN et d'un métal, la granulométrie de la poudre d'UN peut s'exprimer par une coupe granulométrique de ladite poudre.

Le diamètre maximum des grains d'UN mis en oeuvre est d'au plus 500 µm et préférentiellement d'au plus 200 µm ou encore d'au plus 150 µm.

Quant au métal à l'état de poudre, associé à l'UN pour la formation du noyau par la métallurgie des poudres, il peut être choisi dans le groupe constitué par les métaux tels que l'aluminium, le magnésium, le cuivre, le zirconium, pris seuls ou en mélange. La granulométrie du métal en poudre peut être identique ou sensiblement proche de celle retenue pour l'UN en poudre.

La teneur en UN dans le noyau, exprimé en pourcentage en volume rapporté au volume du noyau, est au plus d'environ 70%.

La méthode de préparation d'une cible, dite de type I, selon l'invention dont le noyau est réalisé par la métallurgie des poudres, comporte d'abord la préparation du noyau uranifère puis son association mécanique avec des plaques métalliques formées du même métal ou d'alliages dont l'un au moins des métaux est choisi dans le groupe constitué par l'aluminium, le magnésium, le cuivre, le zirconium.

La poudre d'UN de granulométrie souhaitée est mélangée avec de la poudre métallique choisie dans les groupes précités, en respectant la valeur maximale du pourcentage en volume évoqué ci-dessus. Le mélange de poudres est ensuite compacté à des pressions au plus égales à 70 kg/mm$^2$ et préférentiellement comprises entre environ 30 et 60 kg/mm$^2$.

La mise en oeuvre du UN dans la réalisation de la cible selon l'invention, par la métallurgie des poudres, présente un intérêt majeur grâce aux résultats qu'il procure.

Dans le cas, par exemple, de la réalisation d'un noyau par le mélange d'UN en poudre avec de l'aluminium en poudre, on a pu constater que la quantité d'uranium présente (exprimée en grammes) par unité de volume de noyau (exprimée en cm$^3$) est augmentée d'un facteur d'au plus 4 fois et généralement d'au plus 3 fois, par rapport à un noyau de même dimension réalisé dans les mêmes conditions par mélange d'un alliage UAl$_x$ (x = 3 ou 4) en poudre avec de l'aluminium en poudre.

A titre illustratif, un noyau de cible réalisé à partir d'un mélange de nitrure d'uranium (UN) et d'aluminium (Al) a conduit à une quantité d'uranium total (Ut) de l'ordre de 3,3g Ut/cm$^3$.

A titre comparatif, un noyau de cible réalisé dans les mêmes conditions expérimentales à partir d'un mélange pulvérulent de l'alliage UAl$_x$ (avec x = 3,5) et d'aluminium, a conduit à une quantité d'uranium total de l'ordre de 1,1 g Ut/cm$^3$.

Ainsi, dans une cible de même géométrie, conforme à la présente invention, on pourra produire trois fois plus de molybdène-99.

Par la suite, le noyau formé d'UN et d'aluminium est placé à l'intérieur d'un cadre métallique dont la matière constitutive est de l'aluminium, du magnésium, du zirconium, du cuivre ou un alliage tel que aluminium 1050A (aluminium à 99,5 % selon la norme NFA02-104), AlMg$_3$, AlMg$_2$, AlFeNi,...

Puis les deux faces de l'assemblage noyau-cadre sont recouvertes d'une surface réalisée dans un matériau du même type ou proche du matériau utilisé pour le cadre. L'ensemble obtenu constitue un sandwich dont les surfaces de contact ont été rendues compatibles.

Le sandwich ainsi préparé est soumis à un traitement thermique à une température toujours inférieure à celle de diffusion de l'UN avec l'élément de structure. Cette température est par exemple au plus égale à 580°C et préférentiellement comprise entre 200°C et 500°C si le cadre est un alliage d'aluminium.

Le sandwich est ensuite laminé pour amener le noyau uranifère aux dimensions finales souhaitées. La plaque résultant du laminage est enfin définitivement mise aux cotes nécessaires pour son utilisation, sous forme plane, courbe ou cylindrique.

Les plaques obtenues par le laminage des sandwichs précités sont par la suite assemblées dans une structure porteuse pour constituer le dispositif qui sera soumis à irradiation.

Selon une autre méthode de réalisation d'une cible dite de type II, la cible primaire selon l'invention peut être formée d'une structure plane, courbe ou cylindrique creuse, réalisée en métal, tel que acier inoxydable, nickel, zirconium, aluminium, cuivre, .... ou encore un alliage métallique, dont l'une des faces, en particulier interne (dans le cas de la structure cylindrique creuse) rendue lisse est revêtue d'une couche adhérente continue et régulière d'UN, matière fissile mise en oeuvre.

Dans le cas d'une cible de forme cylindrique et creuse, chaque extrémité de la cible est obturée d'une manière étanche, par une plaque de métal identique à, ou compatible métallurgiquement avec celui utilisé pour le corps cylindrique. La cible ainsi formée, munie de son revêtement d'UN, doit être apte à résister aux températures et pressions provoquées par son exposition dans un flux neutronique.

Toutefois, ladite cible est munie des divers moyens tels qu'orifices d'accès pouvant être clos, permettant la réalisation du revêtement interne d'UN , et de la dissolution ultérieure du molybdène-99 et des autres produits de fission après l'irradiation neutronique de la cible.

L'UN, matière fissile mise en oeuvre, est déposé sur l'une des faces, en particulier interne dans le cas d'une structure cylindrique creuse, sous la forme d'une couche continue adhérant à ladite surface et d'épaisseur régulière, par l'un ou l'autre des moyens connus permettant le dépôt de ladite couche, et en particulier :

- par le procédé de "dépôts chimiques d'une phase gazeuse" (chemical vapor deposition : C.V.D.) ;
- par le procédé de "dépôts physiques en phase vapeur" (physic vapor deposition: P.V.D.).

Quand le dépôt d'UN est réalisé par "dépôt chimique à partir d'une phase gazeuse" (C.V.D.), le procédé de réalisation dudit dépôt consiste à mettre en contact dans une enceinte appropriée, une phase gazeuse formée des éléments constitutifs du revêtement, c'est-à-dire d'un composé chimique de l'uranium, de l'hydrogène et de l'azote ou de l'ammoniac, avec la surface du substrat à recouvrir, la phase gazeuse ainsi formée donnant naissance au revêtement solide sur ladite surface.

La production du dépôt s'effectue par une réaction soit sur la surface du substrat, soit dans la phase gazeuse, et ledit dépôt est d'autant plus homogène que les conditions expérimentales, en particulier température et pression, favorisent plutôt la réaction sur le substrat.

Dans un tel procédé, le substrat à revêtir est placé dans une enceinte appropriée, chauffée et soumise à une pression adaptée au traitement. L'environnement du substrat à revêtir est constitué par la phase gazeuse précédemment évoquée, comprenant, entre autres, un gaz réducteur qui est continuellement renouvelé par la circulation de ladite phase.

Préalablement au dépôt, la surface du substrat est traitée par du gaz réactif en circulation (mélange d'azote et du gaz réducteur hydrogène) pour la dépassiver et la décaper et permettre dès lors que le dépôt s'effectue avec une bonne adhérence et une bonne homogénéité de surface.

La phase gazeuse formée des éléments constitutifs du revêtement, par exemple d'UF$_6$ qui est à l'état solide à température ambiante, d'azote et d'hydrogène, est préparée de manière connue. L'une des méthodes de préparation de ladite phase gazeuse, consiste à placer l'$UF_6$ dans une enceinte à température constante et d'un niveau suffisant pour provoquer son évaporation par tension de vapeur. Le mélange gazeux d'azote et d'hydrogène circulant dans cette enceinte se charge en vapeur de $UF_6$, en quantité contrôlée, et la phase gazeuse ainsi préparée est envoyée dans l'enceinte de traitement du substrat.

La phase gazeuse de réaction comprenant en quantité légèrement supérieure à la stoéchiométrie, $UF_6$, $N_2$ ou $NH_3$ et $H_2$, est mise en contact avec le substrat de telle sorte que soit fabriqué dans l'enceinte, sur ledit substrat, de l'UN, selon l'une des réactions :

$$UF_6 + \tfrac{1}{2} N_2 + 3 H_2 \Rightarrow UN + 6 HF$$

ou

$$UF_6 + NH_3 + 3/2 H_2 \Rightarrow UN + 6 HF$$

ou encore

$$UF_6 + 2 NH_3 \Rightarrow UN + 6 HF + \tfrac{1}{2} N_2.$$

La pression à l'intérieur de l'enceinte de traitement est réglée dans l'intervalle de 100 à 3000 Pascal et préférentiellement dans l'intervalle de 100 à 2000 Pascal.

La température à laquelle s'effectuent les réactions de dépôt sur la surface du substrat se situe dans l'intervalle de 300°C à 850°C, température pour laquelle la cinétique de croissance du dépôt de UN est de l'ordre d'au moins 15 mg/cm$^2$/heure. Pour réduire la température à laquelle s'effectuent les réactions, le procédé peut être assisté par plasma. Une telle assistance permet d'abaisser la température du substrat de façon conséquente, l'intervalle de température se situant entre 100°C et 600°C, température pour laquelle la cinétique de croissance du dépôt est également de l'ordre d'au moins 15 mg/cm$^2$/heure.

Quand le dépôt d'UN est réalisé par "dépôt physique en phase vapeur" (P.V.D.), le procédé de réalisation dudit dépôt consiste à pulvériser la matière à déposer sur le substrat et à la transférer sur ledit substrat par voie physique.

Selon ce procédé P.V.D., le dépôt de la matière (de l'UN) sur le substrat peut se faire par voie ionique ou par pulvérisation cathodique.

Dans le cas où le dépôt de la matière se fait par voie ionique, de l'UN est formé dans une enceinte appropriée et déposé sur le substrat (présent dans la dite enceinte) par réaction entre de l'uranium sous forme vapeur et de l'azote. Cette réaction est provoquée par les particules générées lors d'une décharge électrique pratiquée dans le mélange gazeux formé par l'azote (gaz support de décharge) et la vapeur d'uranium.

Pour ce faire, dans une enceinte de traitement travaillant sous une pression réglée, de l'uranium est placé dans un réceptacle chauffé pour être extrait en présence d'azote. Le réceptacle contenant l'uranium constitue l'anode d'un système à deux électrodes, la cathode étant le substrat sur lequel est effectué le dépôt d'UN.

Entre l'anode et la cathode est appliquée une haute tension tandis qu'une densité de courant de décharge adéquate est pratiquée.

L'enceinte, quant à elle, est reliée à la terre.

La température du matériau à extraire est au moins égale à sa température de fusion. Elle est préférentiellement comprise dans l'intervalle de 1150° C à 1300°C. La tension appliquée entre les électrodes est choisie dans l'intervalle de 3 kV à 10 kV. La densité de courant de décharge est choisie dans l'intervalle de 50 A/m$^2$ à 150 A/m$^2$. La pression régnant à l'intérieur de l'enceinte contenant le gaz support de décharge (argon par exemple puis azote ou mélange de ces deux gaz) se situe dans l'intervalle de 1 Pascal à 10 Pascal.

Avant d'amorcer l'étape de dépôt de l'UN sur le substrat, la surface dudit substrat est soumise à une action de nettoyage par un bombardement ionique provoqué par le déclenchement d'une décharge électrique entre la cathode et l'enceinte en présence d'un gaz support de la décharge (argon, krypton ou xénon).

Après cette étape de nettoyage, s'effectue l'étape du dépôt de l'UN sur le substrat. Pour ce faire, de l'azote est introduit dans l'enceinte. Grâce à la présence simultanée dans ladite enceinte d'uranium et d'azote alors que se produit la décharge électrique, les particules générées dans le milieu gazeux provoquent la réaction entre le gaz support de décharge (azote), et l'uranium occasionnant la création d'une couche d'UN sur le substrat.

Dans le cas où le dépôt de la matière sur le substrat est effectué par pulvérisation cathodique, de l'UN est aussi formé et déposé sur le substrat par réaction entre de l'uranium pulvérisé et de l'azote, gaz réactif.

Pour réaliser la pulvérisation de l'uranium métal et la formation de l'UN, et le dépôt sur le substrat, le procédé se pratique sous vide, à froid, en plasma luminescent dans un gaz réactif (l'azote) (en présence d'un gaz neutre tel que argon, krypton ou xénon) maintenu à pression réduite.

Selon le procédé, le matériau à déposer sur le substrat est placé dans une enceinte munie de deux électrodes de polarité opposée, sous vide. Le matériau à déposer est utilisé comme cathode, alors que le substrat recevant le dépôt constitue l'anode.

Dans des conditions de pression de gaz réactif (azote) données, un champ électrique est créé entre les deux électrodes provoquant l'ionisation du gaz présent et sa luminescence parce que devenu conducteur. Simultanément à cette luminescence, il s'établit un courant entre les électrodes donnant naissance à des électrons attirés par l'anode et des cations attirés par la cathode. L'action des ions positifs (cations) sur la cathode, c'est-à-dire sur le matériau à déposer sur le substrat, provoque l'éjection de matière (atomes : dans le cas de l'uranium métal) sous l'effet du choc des ions : les atomes ainsi éjectés détiennent une énergie très élevée et sont capables de se déposer sur le substrat en formant le dépôt souhaité (UN), fortement adhérent à la surface dudit substrat.

Pour augmenter la vitesse de dépôt, une pulvérisation magnétron peut être utilisée, qui consiste à combiner au niveau de la cathode un champ magnétique intense perpendiculaire au champ électrique créé par la cathode.

La tension appliquée entre les électrodes est choisie dans l'intervalle de 1 kV à 10 kV. La densité de courant est choisie dans l'intervalle de 5 A/m$^2$ à 10 A/m$^2$. La pression régnant à l'intérieur de l'enceinte contenant le gaz réactif (azote) se situe dans l'intervalle de 10$^{-4}$ Pascal à 10$^{-2}$ Pascal. Le débit du gaz réactif (azote) est compris dans l'intervalle de 1 l/h à 10 l/h.

Avant de réaliser l'étape de dépôt de l'UN sur le substrat, la surface dudit substrat est soumise à une action de nettoyage par effluvage et/ou par bombardement ionique, en utilisant un cache devant la cathode, cache qui est retiré après ledit nettoyage.

Selon l'une ou l'autre des méthodes précédemment évoquées pour réaliser le dépôt de l'UN sur le substrat :

- l'épaisseur de la couche de nitrure d'uranium (UN) peut varier entre 10 μm et 500 μm, et préférentiellement entre 10 μm et 150 μm en C.V.D. et entre 1 μm et 100 μm en P.V.D., en particulier quand le dépôt est assisté par magnétron ;

- la quantité en poids de nitrure d'uranium (UN) déposé par unité de surface peut être au plus de 700 mg/cm$^2$ et peut varier préférentiellement entre 16 mg/cm$^2$ et 215 mg/cm$^2$.

L'invention est illustrée par les exemples suivants :

**Exemple 1**

On a réalisé une cible primaire (de type I) pour la formation par irradiation du radio-isotope molybdène-99, par la méthode de la métallurgie des poudres en préparant des noyaux au moyen d'un mélange en poudre de nitrure d'uranium (UN) et d'aluminium, et en insérant les noyaux dans une structure d'aluminium pour constituer un sandwich.

Pour ce faire, on a utilisé une poudre d'UN obtenue par réduction carbothermique d'un oxyde d'uranium $U_3O_8$ ou $UO_2$ selon l'une ou l'autre des réactions suivantes :

$$1/3 \ U_3O_8 + 1/3 \ C \Rightarrow UO_2 + 1/3 \ CO_2$$

ou

$$UO_2 + 2 \ C + \tfrac{1}{2} \ N_2 \Rightarrow UN + 2 \ CO$$

On a obtenu de l'UN sous forme d'une éponge dont la densité est d'environ 50 % de la densité théorique de l'UN.

Par broyage, compactage et frittage successifs, on a réalisé une pastille d'UN ayant une densité très proche de la densité théorique.

Cette pastille a été ensuite broyée sous atmosphère neutre (azote ou argon ou mélange) puis la poudre d'UN a été tamisée de façon à recueillir une coupe granulométrique de la dite poudre d'UN ne dépassant pas 150 μm.

La poudre d'UN tamisée de granulométrie déterminée a été ensuite pesée puis mélangée avec de la poudre d'aluminium de même granulométrie que pour l'UN, à raison de :

- % en poids d'UN : 63 % (ou 25 % en volume) ;
- % en poids d'aluminium : 37 % (ou 75 % en volume).

Le mélange de ces deux poudres a été, par la suite, compacté à froid en presse (40 kg/mm$^2$), donnant des noyaux rectangulaires.

Les noyaux ainsi obtenus ont été insérés dans une structure (cadre et couvercle) d'aluminium préalablement décapée. L'ensemble obtenu constitue un "sandwich". Ce sandwich a été ensuite laminé à chaud, à une température inférieure à 550°C, par passe d'au plus 50 %, pour parvenir à une épaisseur d'environ 1 millimètre pour la cible, avec une densité d'uranium total dans l'âme fissile de 3,3 g Ut/cm$^3$. Avec les mêmes charges volumiques de composés uranifères du type UAlx, on aurait obtenu 1,1 g Ut/cm$^3$.

La plaque ainsi réalisée a été mise en forme pour obtenir une surface courbe ou un tube : elle constitue une cible.

La cible a été alors logée dans un dispositif approprié, ultérieurement placé dans un réacteur nucléaire afin d'obtenir, par fission de l'uranium, du molybdène-99.

Au terme de cette irradiation, la cible a été traitée chimiquement pour en extraire le molybdène-99.

Dans une première étape, la cible a été traitée par une solution alcaline (de NaOH ou KOH) pour dissoudre l'aluminium et solubiliser certains produits de fission, dont le molybdène.

Puis on a procédé à une filtration qui permet de séparer un hydroxyde d'uranium et une solution basique de molybdène. L'hydroxyde d'uranium a été récupéré pour un retraitement jusqu'à l'oxyde, qui a été réutilisé dans la fabrication de la cible.

La solution basique contenant le molybdène a été, selon les méthodes connues, purifiée par adsorption sur colonne puis élution sélective jusqu'à l'obtention du molybdène pur sous la forme chimique appropriée à son utilisation dans le générateur de technétium-99.

Cet exemple fait ainsi apparaître, en aval, une simplification dans la phase de séparation post-irradiation du molybdène-99 de l'oxyde d'uranium qui peut être recyclé par réduction carbothermique dans la fabrication d'une nouvelle cible conforme à l'invention.

## Exemple 2

On a réalisé une cible primaire (de type II) par dépôt chimique de nitrure d'uranium (UN) à partir d'une phase réactionnelle gazeuse (méthode C.V.D.) à l'intérieur d'un tube métallique constituant le substrat, en mettant en oeuvre l'une ou l'autre des réactions chimiques :

$$UF_6 + \tfrac{1}{2} N_2 + 3 H_2 \Rightarrow UN + 6 HF \tag{1}$$

$$UF_6 + NH_3 + 3/2 H_2 \Rightarrow UN + 6 HF \tag{2}$$

Pour ce faire, le tube métallique dont la surface interne doit être revêtue d'UN a été choisi en acier inoxydable austénitique (type AISI 316 L) en raison de sa compatibilité avec le dépôt d'UN, de sa capacité à être soudé sans précautions extrêmes et de sa facilité à être mis en oeuvre.

Ce tube métallique avait un diamètre interne de 30 mm, une épaisseur de paroi de 4 mm et une longueur de 700 mm.

Ce tube a servi simultanément de substrat pour le dépôt de l'UN et d'enceinte de réaction.

Le tube a été raccordé en amont à un dispositif d'alimentation en gaz de réaction et en aval à une évacuation des gaz réactifs en excès et des produits de la réaction et comportait un dispositif de mise sous vide.

Pour que la réaction chimique [selon (1) ou (2)] se produise, il a été nécessaire de l'activer par un apport thermique en chauffant le substrat.

Une cinétique de dépôt significatif a été obtenue lors d'essais préliminaires :

- à 550°C en pratiquant le mélange réactionnel (1) ;
- à 350°C en pratiquant le mélange réactionnel (2) ;

Le dispositif d'alimentation en gaz comportait :

- une source d'UF$_6$ maintenue en bain thermostaté pour disposer d'une pression de vapeur suffisante et contrôlée

en $UF_6$, sous forme gazeuse, entraînée par un gaz porteur (argon et/ou azote), le débit en étant contrôlé ;
- des sources de gaz réactifs ($H_2$, $N_2$ ou $NH_3$), le débit de chaque gaz étant contrôlé ;
- un mélangeur des divers gaz réactifs mis en oeuvre pour le dépôt de l'UN ($UF_6$, $H_2$, $N_2$ ou $NH_3$).

Les moyens de mise sous vide et d'évacuation des gaz réactifs en excès et des produits de réaction comportaient :

- une vanne pointeau en amont du mélangeur de gaz ;
- un système de mesure de la pression dans le tube réactionnel ;
- une vanne de réglage de la pression de dépôt en aval du tube réactionnel ;
- un dispositif de pompage assurant une pression interne comprise entre 10 Pascal et 1000 Pascal,
- et des dispositifs de filtration et d'épuration des gaz sortant de l'installation.

Le tube réactionnel a été chauffé et maintenu à une température d'environ 690°C, la température du substrat étant suivie par pyrométrie optique. La partie externe du tube était protégée de toute oxydation par une circulation d'un gaz protecteur (argon et/ou azote).

Pour la réalisation du dépôt de l'UN, l'installation a été purgée, mise sous vide et parcourue par un mélange gazeux comprenant de l'argon et de l'hydrogène (10%) à la pression de 100 Pascal.

La régulation du bain thermostaté a été réglée sur 18°C pour assurer une pression partielle de 1000 Pascal.

Le tube réactionnel a été porté à la température de réaction choisie de 690°C.

Les débits d'$UF_6$, d'azote et d'hydrogène ont été établis (respectivement 3 %, 5 % et 92 %), indépendamment du débit d'argon porteur (7.6 fois plus élevé que celui d'$UF_6$)

La cinétique de dépôt, dans les conditions précitées, a atteint environ 15 µm à l'heure, pour une bonne densité de dépôt et une régularité d'épaisseur raisonnable.

A la fin du dépôt, l'alimentation en $UF_6$ a été arrêtée, l'installation nettoyée à l'argon, le chauffage coupé et le refroidissement s'est effectué sous vide en présence d'un courant gazeux d'un mélange d'azote et d'hydrogène.

Par comparaison avec un dépôt d'oxyde, du type $U_3O_8$, de même épaisseur que précitée, on dépose 1,9 fois plus d'uranium (dans le cadre de la cible selon l'invention) que selon l'état de la technique (et 1,4 fois plus d'uranium qu'avec un dépôt de $UO_2$).

Le tube dont la surface interne est revêtue d'UN constitue la cible primaire selon l'invention pour la formation du produit de fission molybdène-99.

Le tube-cible est alors clos d'une manière étanche dans une atmosphère d'hélium.

La cible est ensuite logée dans un dispositif approprié. L'ensemble ainsi formé est placé dans un réacteur nucléaire afin d'obtenir, par fission de l'uranium-235, du molybdène-99.

Au terme de l'irradiation, la cible est traitée chimiquement pour en extraire le molybdène-99, par un milieu acide, selon les méthodes connues.

Puis par passages successifs sur colonnes et élutions acides ($H_2SO_4$) ou alcaline (NaOH) contenant le molybdène-99, on achève par une solution isotonique de molybdène-99. Le molybdène-99 est ensuite adsorbé par passage de la dite solution dans une colonne d'alumine : l'adsorption du molybdène-99 est très supérieure à 99,99 %. Le technécium-99 accumulé dans la colonne est élué à la demande avec une solution saline isotonique.

**Revendications**

1.   Cible primaire pour la production par irradiation neutronique dans un réacteur nucléaire du produit de fission molybdène-99 à de fortes concentrations, de forte activité spécifique et haut degré de pureté, à partir d'une matière fissile à base d'uranium, , **caractérisée en ce que** la matière fissile est majoritairement constituée, en masse, de nitrure d'uranium.

2.   Cible primaire selon la revendication 1, dite de type I, **caractérisée en ce qu'**elle est formée d'un volume plan ou courbe comprenant un noyau préparé par métallurgie des poudres par mélange de poudre de nitrure d'uranium et de poudre d'un métal.

3.   Cible primaire de type I, selon la revendication 2, **caractérisée en ce que** le métal pulvérulent est choisi dans le groupe constitué par l'aluminium, le magnésium, le cuivre, le zirconium, chacun pris seul ou en mélange.

4.   Cible primaire de type I selon l'une quelconque des revendications 1 à 3, **caractérisée en ce que** la teneur en nitrure d'uranium, exprimée en pourcentage en volume rapporté au volume du noyau, est d'au plus 70 %.

**5.** Cible primaire selon la revendication 1 , dite de type II, **caractérisée en ce qu'**elle est formée de supports plans, courbes ou cylindriques, revêtus de nitrure d'uranium.

**6.** Cible primaire de type II selon la revendication 5, **caractérisée en ce que** le noyau, essentiellement formé de nitrure d'uranium, est placé à l'intérieur d'un cadre métallique, puis l'assemblage noyau-cadre est recouvert sur ses deux faces de surfaces de recouvrement et forme un sandwich et **en ce que** les surfaces de recouvrement sont réalisées en une matière choisie dans le groupe constitué par l'aluminium, le magnésium, le zirconium, le cuivre ou un alliage aluminium-magnésium ou un alliage aluminium-fer-nickel.

**7.** Cible primaire de type II selon la revendication 5, **caractérisée en ce qu'**elle est formée d'une structure métallique cylindrique et creuse dont l'une des faces est revêtue d'une couche de nitrure d'uranium.

**8.** Cible primaire de type II selon la revendication 5, **caractérisée en ce qu'**elle est formée d'une structure métallique cylindrique creuse, chaque extrémité de la structure cylindrique étant obturée par des plaques munies d'orifices d'accès pouvant être clos.

**9.** Méthode de préparation de la cible de type I selon les revendications 1 à 4, **caractérisée en ce qu'**elle comporte la réalisation du noyau uranifère et son association mécanique avec des plaques métalliques pour former un assemblage et **en ce que** le noyau uranifère est réalisé par compactage à une pression d'au plus 70 kg/mm$^2$ du mélange de poudres de nitrure d'uranium et du métal choisi dans le groupe constitué par l'aluminium, le magnésium, le cuivre, le zirconium.

**10.** Méthode selon la revendication 9, **caractérisée en ce que** la pression de compactage est comprise entre environ 30 kg/mm$^2$ et environ 60 kg/mm$^2$.

**11.** Utilisation de la cible selon les revendications 1 à 9 à la production de molybdène-99 par irradiation neutronique dans un réacteur nucléaire et à la production de technécium-99 à des fins de recherche et/ou diagnostics médicaux et/ou industriels.

## Patentansprüche

**1.** Primärziel zur Erzeugung - durch Neutronenbestrahlung in einem Kemreaktor - des Spaltprodukts Molybdän-99 mit hohen Konzentrationen, hoher spezifischer Aktivität und hohem Reinheitsgrad, **dadurch gekennzeichnet, dass** das spaltbare Material, als Masse, hauptsächlich durch Urannitrid gebildet wird.

**2.** Primärziel nach Anspruch 1, als Typ I bezeichnet, **dadurch gekennzeichnet, dass** es durch ein ebenes oder gekrümmtes Volumen gebildet wird, das einen pulvermetallurgisch durch das Mischen des Pulvers von Urannitrid und des Pulvers eines Metalls hergestellten Kern umfasst.

**3.** Primärziel des Typs I nach Anspruch 2, **dadurch gekennzeichnet, dass** das feinpulvrige Metall aus der Gruppe ausgewählt wird, die gebildet wird durch das Aluminium, das Magnesium, das Kupfer, das Zirkon, die einzeln oder als Mischung verwendet werden.

**4.** Primärziel des Typs I nach einem der Ansprüche 1 bis 3, **dadurch gekennzeichnet, dass** der Urannitridgehalt, ausgedrückt in Volumenprozent in Bezug auf das Volumen des Kerns, höchstens 70% beträgt.

**5.** Primärziel nach Anspruch 1, als Typ II bezeichnet, **dadurch gekennzeichnet, dass** es durch mit Urannitrid überzogene ebene, gekrümmte oder zylindrische Träger gebildet wird.

**6.** Primärziel des Typs II nach Anspruch 5, **dadurch gekennzeichnet, dass** der im Wesentlichen durch Urannitrid gebildete Kern im Innem eines Metallrahmens angebracht wird, dann der Zusammenbau aus Kern und Rahmen auf seinen beiden Oberflächen-Flächen mit einem Überzug überzogen wird und einen Sandwich bildet, und **dadurch**, dass die Überzugsoberflächen aus einem Material realisiert werden, das ausgewählt wird aus der Gruppe, die gebildet wird durch das Aluminium, das Magnesium, das Zirkon, das Kupfer oder eine Aluminium-Magnesium-Legierung oder eine Aluminium-Eisen-Nickel-Legierung.

**7.** Primärziel des Typs II nach Anspruch 5, **dadurch gekennzeichnet, dass** es durch eine zylindrische und hohle Metallstruktur gebildet wird, bei der eine der Seiten mit einer Urannitridschicht überzogen ist.

8. Primärziel des Typs II nach Anspruch 5, **dadurch gekennzeichnet, dass** es durch eine zylindrische und hohle Metallstruktur gebildet wird, wobei jedes Ende der zylindrischen Struktur durch Platten verschlossen ist, die verschließbare Zugangsöffnungen aufweisen.

9. Verfahren zur Herstellung des Ziels des Typs I nach den Ansprüchen 1 bis 4, **dadurch gekennzeichnet, dass** es die Realisierung des uranhaltigen Kerns und seine mechanische Verbindung mit Metallplatten umfasst, um einen Zusammenbau zu bilden, und **dadurch**, dass der uranhaltige Kern durch Kompaktierung der Mischung aus den Pulvern des Urannitrids und des unter Aluminium, Magnesium, Kupfer und Zirkon ausgewählten Metalls mit einem Druck von höchstens 70 kg/mm$^2$ realisiert wird.

10. Verfahren nach Anspruch 9, **dadurch gekennzeichnet, dass** der Kompaktierungsdruck zwischen ungefähr 30 kg/mm$^2$ und ungefähr 60 kg/mm$^2$ enthalten ist.

11. Verwendung des Ziels nach den Ansprüchen 1 bis 9 zur Erzeugung von Molybdän-99 durch Neutronenbestrahlung in einem Kernreaktor, und zur Erzeugung von Technetium-99 zu medizinischen und/oder industriellen Forschungs- und/oder Diagnosezwecken.

**Claims**

1. Primary target for the production by means of neutron irradiation in a nuclear reactor of the fissile product molybdenum-99 at high concentrations, with high specific activity and a high degree of purity, from a uranium-based fissile material, **characterised in that** the fissile material consists for the most part, by mass, of uranium nitride.

2. Primary target according to claim 1, designated as type I, **characterised in that** it is formed from a plane or curved volumetric space comprising a core made by powder metallurgy by mixing uranium nitride powder with a metal powder.

3. Primary target of type I according to claim 2, **characterised in that** the powdered metal is selected from the group formed by aluminium, magnesium, copper, zirconium, each one used singly or in combination.

4. Primary target of type I according to any one of claims 1 to 3, **characterised in that** the content of uranium nitride, expressed in percentage by volume in relation to the volume of the core, is at most 70%.

5. Primary target according to claim 1, designated as type II, **characterised in that** it is formed from plane, curved or cylindrical supports coated with uranium nitride.

6. Primary target of type II according to claim 5, **characterised in that** the core, made essentially of uranium nitride, is placed inside a metal frame, then the core-frame assembly is coated on its two faces of covering surfaces and forms a sandwich, and **in that** the covering surfaces are made from a material selected from the group formed by aluminium, magnesium, zirconium, copper or an aluminium-magnesium alloy or an aluminium-iron-nickel alloy.

7. Primary target of type II according to claim 5, **characterised in that** it is formed from a metal cylindrical, hollow structure, one of the surfaces of which is coated with a layer of uranium nitride.

8. Primary target of type II according to claim 5, **characterised in that** it is formed from a metal, cylindrical hollow structure, each end of the cylindrical structure being sealed by plates provided with access openings which are able to be closed.

9. Method for preparing the target of type I according to claims 1 to 4, **characterised in that** it comprises making the uranium-containing core and its mechanical association with metal plates to form an assembly, and **in that** the uranium-containing core is achieved by compaction at a pressure of at most 70 kg/mm$^2$ of the mixture of uranium nitride powder and a metal powder selected from the group formed by aluminium, magnesium; copper and zirconium.

10. Method according to claim 9, **characterised in that** the compaction pressure is between approximately 30 kg/

$mm^2$ and approximately 60 kg/ $mm^2$.

11. Use of the target according to claims 1 to 9 for the production of molybdenum-99 by neutron irradiation in a nuclear reactor and for the production of technetium-99 for the purpose of medical and/or industrial research and/or diagnosis.